# EUROPEAN PATENT SPECIFICATION

(11) **EP 4 488 058 B1**
(45) Date of publication and mention of the grant of the patent: **17.12.2025**
(21) Application number: 23184181.8
(22) Date of filing: 07.07.2023
(51) Int. Cl.: B32B 7/025, B32B 7/027

(54) **THERMAL MANAGEMENT COMPOSITE SHEET, METHOD FOR PRODUCING THE SAME AND CAR, BATTERY CASE, COMPUTER CASE AND SENSOR CASE COMPRISING THE SAME**
WÄRMEVERWALTUNGSVERBUNDFOLIE, VERFAHREN ZUR HERSTELLUNG DAVON UND AUTO, BATTERIEGEHÄUSE, COMPUTERGEHÄUSE UND SENSORGEHÄUSE DAMIT
FEUILLE COMPOSITE DE GESTION THERMIQUE, SON PROCÉDÉ DE PRODUCTION ET VOITURE, BOÎTIER DE BATTERIE, BOÎTIER D'ORDINATEUR ET BOÎTIER DE CAPTEUR LA COMPRENANT

(43) Date of publication of application: 08.01.2025
(73) Proprietor: Euro Advanced Carbon Fiber Composites GmbH, 73730 Esslingen Am Neckar (DE)
(72) Inventor: SCHMIDT, Tobias, 72127 Kusterdingen (DE); SAPRA, Rahulkumar, 47805 Krefeld (DE)
(74) Representative: Hoefer & Partner Patentanwälte mbB

(56) References cited:
- JP-A- H0 946 082
- US-A1- 2016 056 512
- US-A1- 2019 208 654
- US-A1- 2019 348 653

## Description

The present invention relates to a thermal management composite sheet and a method for producing the same. The present invention further concerns a car, a battery case, a computer case or a sensor case comprising the thermal management composite sheet (TMS in the following).

In order to provide electromagnetic shielding properties and fire retardancy, which are essential features particularly for an electronic device, such as a battery, a computer or a sensor, there are used laminates of electromagnetic shielding components and fire retardant components in form of separate layers. The layers may be laminated using adhesives, such as resins and the like. To further adjust the temperature in the electronic devices and thus, to improve the temperature management, the electronic devices often use heating wires and/or cooling tubes to be filled with coolant.

Usually the properties to be realized in the electronic device are realized in separate layers, which increases the weight of the electronic device and complicates the manufacture of the electronic device.

US 2016/056512 A1 teaches a heat exchanger component of a temperature control system of an electrical energy store may include a carrier material and at least two layers. The at least two layers may include a first layer composed of an electrically insulating material and a second layer that may facilitate temperature control via at least one of cooling and heating the electrical energy store.

US 2019/348653 A1 teaches a cover for a battery housing of a high-voltage vehicle battery. The cover includes a composite material which for its part comprises a polymer matrix and an at least fire retardant material embedded in said polymer matrix. In addition, the cover includes an electrically conductive layer, which forms an electromagnetic shield.

US 2019/208654 A1 teaches an electronic device housing, which consists mainly of a fiber reinforcing member (a) and a fiber reinforcing member (b), the fiber reinforcing member (a) containing a resin (a1) and a fiber (a2), the fiber reinforcing member (b) containing a resin (b1) and a fiber (b2), the fiber reinforcing member (a) and the fiber reinforcing member (b) being joined directly without the existence of another layer at the joining face between the fiber reinforcing member (a) and the fiber reinforcing member (b), and the fiber reinforcing member (a) and the fiber reinforcing member (b) fulfilling a specific relation in terms of linear expansion coefficient and/or bending elastic modulus.

JP H09 46082 A teaches a fiber reinforces plastic (FRP), which is formed by molding the material, wherein carbon fiber woven material or carbon continuous fibers arranged in a sheet in one direction is impregnated with resin. A first layer (outer layer) of a note type personal computer cabined which layer is composed of FRP is molded. A second layer (inner layer) of the personal note computer cabinet is molded, which layer is formed by injection-molding or transfer-molding resin or resin containing short fibers for reinforcement. The layers are stuck together by using adhesive agent or an adhesive tape. Thereby a case for electric-electronic apparatus and a key board retainer, which are lightweight and excellent in characteristics as compared with conventional products can be obtained
Starting from this prior art, it is a problem underlying the present invention to provide a TMS which is light-weight and cost effective. A further object is the provision of a method for effectively and cost-extensively producing a TMS with high rate of production. It is a further object of the present invention to provide a car, a battery case, a computer case or a sensor case comprising the TMS and thus, being optimized in view of operation temperature, electromagnetic shielding properties and fire retardant properties, while having a reduced total weight.

The above objects and problems are solved by the appended independent claims. The dependent claims contain advantageous embodiments of the present invention.

According to an aspect of the present invention, the above object is solved by providing a thermal management composite sheet, which comprises, integrated into a fiber-reinforced plastic, an electromagnetic interference shielding material (EMI material in the following), a fire retardant, and a heating structure and/or a cooling structure. In other words, the inventive TMS is composed of a fiber-reinforced plastic, which due to the inclusion of an EMI material, a fire retardant and either a heating structure or a cooling structure or both of a heating structure and a cooling structure has excellent electromagnetic shielding properties, fire retardancy and thermal adjustment ability so that the TMS can be used for sensible electronic devices, such as sensors, battery-containing devices such as cars, computers and the like. Particularly electronic devices such as computers, sensors, and battery containing devices are sensitive to environmental conditions and influences and are sensitive to temperature changes or might need a certain operation temperature so that the use of the inventive TMS improves their long-term reliability and their environmental stability and thus, guarantees for a long lifetime.

Since the inventive TMS is provided in form of one fiber-reinforced plastic including all the above essential components formed to a sheet by using a resin, the TMS is not only of high mechanical stability due to the inclusion of fibers, but is also of extreme light-weight because of the resin fixing the components in the composite sheet. The resin used to form the fiber-reinforced plastic, in which the TMS is integrally formed, can particularly be selected among thermosetting resins, thermoplastic resins or silicone based resins, wherein the resin is particularly selected from polyvinyl alcohol, polyester resins, styrene acrylic resins, polyimide resins, epoxy resins, polyurethane resins and mixtures thereof.

More particular, the heating structure includes electrically conductive wires and the cooling structure includes hollow tubes, and the heating structure and/or the cooling structure is stitched to the fiber material of the fiber-reinforced plastic. While in well-known heating and cooling components, the wires and tubes are most often either loosely provided between two sheets or fixed in resin material between separate sheets, the heating structure and/or the cooling structure used according to the inventive TMS is stitched to fibrous material. Thereby the heating structure and the cooling structure are fixed to fibers used in the fiber-reinforced structure in advance before overmolding the fiber-reinforced structure with resin. This facilitates the handling of the fiber-reinforced structure before molding since all essential components of the TMS to be produced are already fixed to a fibrous sheet. In this regard it is to be mentioned that in case both of the heating structure and the cooling structure are provided, the heating structure and the cooling structure may be provided on the same fibers or fiber portions or on different fibers or fiber portions.

The provision of the inventive TMS in form of one integrally formed fiber-reinforced plastic reduces the weight of the TMS, improves its mechanical stability and increases its functionality since all properties as necessary are combined, such as a fire retardant property, an electromagnetic shielding property and an ability of adjusting the temperature by the TMS.

According to an embodiment of the present invention, the electromagnetic interference shielding material forms a first layer, the fire retardant forms a second layer and the heating structure and/or the cooling structure form at least a third layer, wherein the first, second and third layer(s) are integrated into the fiber-reinforced plastic and thus, form the fiber-reinforced composite sheet. This facilitates the preparation of the TMS and each of the required properties, such as the fire retardancy, the electromagnetic shielding property and the adjustability of the temperature can be provided separately and independent of all other properties so that the components to be used to achieve the desired properties can be selected independently from each other and optimized for the use of the TMS.

According to an alternative embodiment, the electromagnetic interference shielding material and the fire retardant form a fourth layer and the heating structure and/or the cooling structure form at least a third layer, wherein the fourth layer and the third layer(s) are integrated into the fiber-reinforced plastic. Hereby the production process of the TMS can be facilitated and warehouse charges can be reduced since the EMI material and the fire retardant are already formed in one (the fourth) layer.

According to a further alternative embodiment, which even more facilitates the production process and reduces the warehouse charges, the EMI material, the fire retardant and the heating structure and/or the cooling structure form a fifth layer, wherein the fifth layer is integrated into the fiber-reinforced plastic. This means that in case a heating structure and a cooling structure are used, both can be integrated into one (the fifth) layer.

According to a preferable embodiment, the fiber material includes at least one of the following fibers: glass fibers, carbon fibers and recycled carbon fibers. Using the preceding fibers improves the mechanical properties of the TMS while maintaining the weight as low as possible. To improve the eco friendliness, recycled carbon fibers are preferred over (new) carbon fibers.

The type of resin material to be used in the fiber-reinforced plastic is not particularly limited and can be selected in view of the use of the TMS. In view of excellent producibility and high mechanical stability, the plastic material of the fiber-reinforced plastic is preferably at least one selected from the group consisting of: polyester resins, epoxy resins, phenolic resins, silicone resins, polyamide resins, and mixtures and copolymers thereof.

In view of an improvement of the electromagnetic shielding properties of the TMS, the EMS material preferably includes metal coated fibers, wherein the fibers are particularly selected from carbon fibers, glass fibers, polyester fibers, nylon fibers, aramid fibers, modacrylic fibers, olefin fibers, acrylic fibers, rayon fiber, polyamide fibers, and mixtures thereof, and/or wherein the metal of the metal coated fibers is selected from copper, aluminium, silver, cobalt, nickel, mixtures and alloys therefrom.

According to a further preferable embodiment, the fibers of the electromagnetic interference shielding material form a woven fabric, a non-woven fabric, a non-crimp fabric or a fleece. This improves the homogeneity of the EMS material and thus, guarantees constantly high electromagnetic shielding properties.

In the TMS of the present invention, after molding the fiber-reinforced structure with resin, the fibers of the EMS material are in form of resin-impregnated fibers, wherein depending on the resin used to form the fiber-reinforced TMS, the resin is a thermosetting resin, a thermoplastic resin or a silicone based resin, wherein the resin is particularly selected from polyvinyl alcohol, polyester resins, styrene acrylic resins, polyimide resins, epoxy resins, polyurethane resins and mixtures thereof.

In order to achieve high fire retardancy, the fire retardant preferably includes expandable graphite, wherein particularly, the fire retardant is provided in form of a second layer, the second layer including a fiber material selected from the group consisting of: carbon fibers, glass fibers, polyester fibers, aramid fibers, metal-coated carbon fibers, polyphenylenesulphide fibers, polyyetherimide fibers, polyether ether ketone fibers, polyimide fibers and mixtures thereof, and the second layer further including a binder selected from polyvinyl alcohol, polyester resins, styrene acrylic acid resins, polyimide resins, epoxy resins, polyurethane resins and mixtures thereof. The type of binder is preferably the same as used in the fiber-reinforced plastic. More preferably, the binder corresponds to the resin used in the fiber-reinforced plastic and is supplied to the second layer when carrying out the molding step.

The fire retardant properties of the TMS can be further improved when the thickness of the second layer ranges from 30 µm to 6 mm, and/or wherein the areal weight of the second layer ranges from 2 to 200 g/m³, and/or wherein a fiber length of the fiber material ranges from 3 to 25 mm.

According to a further preferable embodiment, the electrically conductive wires of the heating structure are formed from copper, aluminium, iron, nickel, mixtures and alloys therefrom, which increases, due to an increase in the thermal conductivity of the wires, the ability of heating the TMS.

A good balance between light-weight of the TMS on the one hand and excellent heating ability can be achieved by the embodiment in which the electrically conductive wires have an inner diameter ranging from 0.1 to 2.0 mm.

The weight of the TMS can further be reduced, when the hollow tubes of the cooling structure are particularly formed of silicon or a plastic material. This also improves the integrity of the cooling structure in the fiber-reinforced plastic.

According to a further preferable embodiment, the hollow tubes have an inner diameter ranging from 0.1 to 2.0 mm so that the light-weight of the TMS can be further improved.

The mechanical stability of the TMS can be further improved according to an embodiment, in which the heating structure and the cooling structure are stitched to the fiber material of the fiber-reinforced plastic or wherein the heating structure and the cooling structure are stitched to another fiber material, selected from glass fibers, carbon fibers, polyamide fibers, modacrylic fibers, olefin fibers, polyester fibers, rayon fibers, and mixtures thereof, and is then integrated in the fiber-reinforced plastic of the inventive TMS preferably before molding the fiber-reinforced plastic, so that the heating structure and the cooling structure form an integral part of the fiber-reinforced plastic after molding. The another fiber material can preferably be in form of a woven fabric, a non-woven fabric, a non-crimp fabric or a fleece and is optionally impregnated with a resin selected from polyester resins, epoxy resins, phenolic resins, silicone resins, polyamide resins and mixture and copolymers thereof. In case the another fiber material is impregnated with resin, the resin is preferably of the same type used for forming the fiber-reinforced plastic.

To improve the ability of adjusting the temperature by using the TMS, the heating structure and the cooling structure preferably have a meandering structure, which is highly effective.

According to a further aspect of the present invention, a method for producing a thermal management composite sheet is provided herewith. Accordingly, a thermal management device and a fiber-based reinforcing material are placed in a mold. The mold is subsequently closed. Then, pressure and optionally heat are applied to densify the fiber-based reinforcing material. In a further step a resin is introduced into the mold, said resin infiltrating the fiber-based reinforcing material. Thereby the fiber-based reinforced structure is formed into a fiber-reinforced plastic. When the resin is a thermosetting resin, a curing step of curing the resin may subsequently be carried out or when the resin is a thermoplastic resin, the thermal management composite sheet may merely be removed from the mold and may be cooled.

According to the inventive method, the thermal management device comprises an EMI material, a fire retardant, and a heating structure and/or a cooling structure, wherein the heating structure includes electrically conductive wires, wherein the cooling structure includes hollow tubes, and wherein the heating structure and/or the cooling structure is stitched to a fiber material to fix the heating structure and/or the cooling structure to the fibrous material.

Regarding the components used in the method described above, it is supplementary referred to the explanations provided in view of the first aspect of the present invention, i.e. the inventive TMS. Moreover, the inventive TMS can be prepared using the inventive method for producing a TMS.

Therefore, the embodiments can be applied interchangeably.

According to an embodiment, it is preferable that the EMI material is in form of a first layer, the fire retardant is in form of a second layer and the heating structure and/or the cooling structure is in form of at least a third layer. So all three layers can be placed in the mold in an arbitrary sequence.

Alternatively, the electromagnetic interference shielding material and the fire retardant are in form of a fourth layer and the heating structure and/or the cooling structure is in form of at least a third layer. This facilitates the supply of the layers to the mold since the EMI material and the fire retardant merely form one layer.

According to a further preferable embodiment, the EMI material, the fire retardant and the heating structure and/or the cooling structure are in form of a fifth layer. When both, the heating structure and the cooling structure are provided, both can be provided in the fifth layer or one of them can be provided in a separate layer. The provision in only one layer is further preferable in view of the facilitated processability. The provision of all essential components in the fifth layer facilitates the handling and the molding step since a misalignment of separate layers can be prevented.

It is further preferable that the first to fifth layer include a fiber material and a resin. Thereby the mechanical properties of the TMS can be improved, such as the mechanical stability. The fibrous material and the resin material can be of the same type or can be of different types. It is preferable from the viewpoint of easy producibility that throughout all layers, the fibrous material and the resin are of the same type.

The fourth layer is preferably formed according to the following embodiment, in which the method includes a step of providing the EMI material, wherein the EMI material includes metal coated fibers, wherein the fibers are particularly selected from carbon fibers, glass fibers, polyester fibers, nylon fibers, aramid fibers, modacrylic fibers, olefin fibers, acrylic fibers, rayon fibers, polyamide fibers, and mixtures thereof, and/or wherein the metal of the metal coated fibers is selected from copper, aluminium, silver, cobalt, nickel, mixtures and alloys therefrom. The fibers of the EMI material preferably form a woven fabric, a non-woven fabric, a non-crimp fabric or a fleece in order to improve the mechanical stability and the homogeneity of the electromagnetic shielding properties.

In a further step, the EMI material is placed in a mold and then, the fibers of the EMI material are impregnated with a resin, wherein the resin is a thermosetting resin, a thermoplastic resin or a silicone based resin, wherein the resin is particularly selected from polyvinyl alcohol, polyester resins, styrene acrylic resins, polyimide resins, epoxy resins, polyurethane resins and mixtures thereof, and corresponds to the resin used for forming the fiber-reinforced plastic. Then, the flame retardant is applied to the impregnated fibers of the EMI material, and when the resin is a thermosetting resin, the resin is subsequently cured or when the resin is a thermoplastic resin, the fourth layer is removed from the mold and cooled.

Thereby, the EMI material and the fire retardant are easily integrated into the fourth layer and can be used easily for forming the fiber-reinforced plastic. The application of the flame retardant is not limited and processes like spraying, using a binder bath and the like may be used.

As a further (third) aspect of the present invention, a car, a battery case, a computer case or a sensor case is provided, which comprises the above-described thermal management composite sheet. Due to the use of the inventive TMS, the car, the battery case, the computer case and the sensor can are effectively prevented from electromagnetic rays, the car, the battery case, the computer case and the sensor are prevented from catching fire and the thermal conditions for an optimized processability of the car, the battery, the computer and the sensor can be adjusted easily while the weight of the car, the battery, the computer and the sensor is not significantly increased.

More preferably, when using the inventive TMS in a car, the TMS is preferably connected to an air conditioning of the car so that no separate heating or cooling device is necessary, which produces a car with particularly reduced weight.

In view the above advantage, it is further preferable, when a coolant is supplied to the cooling structure of the TMS, which is a chemically stabilized CO₂ based air coolant.

The present invention is also described with reference to the following Figs.:
Fig. 1 shows a sectional view of a thermal management composite sheet in accordance with an embodiment of the present invention and
Fig. 2 shows a top view of a layer including a heating structure and a cooling structure.

In the Figs. merely the essential components of the TMS are shown. All other components are omitted to improve clarity. Throughout the Figs. same reference signs denominate same components/structures.

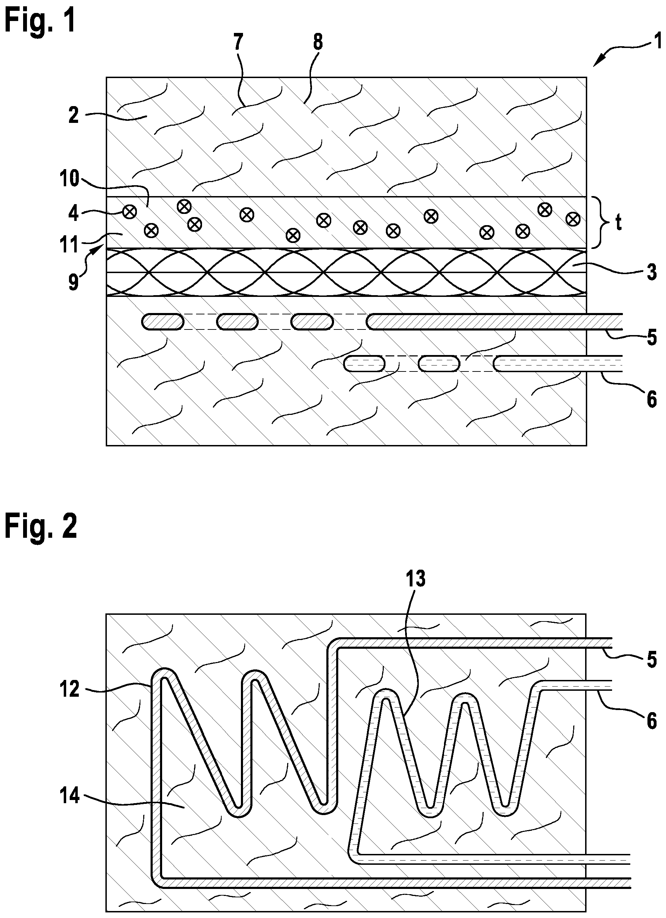

In detail, Fig. 1 shows a thermal management composite sheet (TMS) 1, which comprises, integrated into a fiber-reinforced plastic 2, an electromagnetic interference shielding (EMI) material 3, a fire retardant 4, and a heating structure 5 and a cooling structure 6.

The fiber material 7 of the fiber-reinforced plastic 2 includes at least one of glass fibers, carbon fibers and preferably recycled carbon fibers. The plastic material 8 of the fiber-reinforced plastic 2 is at least one selected from the group consisting of: polyester resins, epoxy resins, phenolic resins, silicone resins, polyamide resins and mixture and copolymers thereof.

The EMI material 3 preferably includes metal coated fibers, wherein the fibers are particularly selected from glass fibers, polyamide fibers, modacrylic fibers, olefin fibers, polyester fibers, rayon fibers and mixtures thereof, and wherein the metal of the metal coated fibers is selected from copper, aluminium, silver, cobalt, nickel, mixtures and alloys therefrom.

The fibers of the EMI material 3 are preferably in form of a woven fabric, a non-woven fabric, a non-crimp fabric or a fleece and is more preferably in form of a woven fabric in order to improve the mechanical stability.

The fire retardant 4 is provided in form of a second layer 9, and the second layer 9 includes a fiber material 10 selected from the group consisting of: carbon fibers, glass fibers, polyester fibers, aramid fibers, metal-coated carbon fibers, polyphenylenesulphide fibers, polyyetherimide fibers, polyether ether ketone fibers, polyimide fibers and mixtures thereof, and the second layer 9 further includes a binder 11 selected from polyvinyl alcohol, polyester resins, styrene acrylic acid resins, polyimide resins, epoxy resins, polyurethane resins and mixtures thereof.

The thickness t of the second layer 9 ranges from 30 µm to 6 mm, and the areal weight of the second layer 9 ranges from 2 to 200 g/m³, and/or a fiber length of the fiber material 10 in the second layer 9 ranges from 3 to 25 mm.

The fire retardant 4 includes expandable graphite, wherein the expandable graphite is integrated into the fibrous material 10 of the second layer 9. In order to integrate the expandable graphite into the fibrous material, a binder is added to the fibrous material 10 of the second layer 9, e.g. by spraying or dipping the second layer 9 into a bath including the binder. Then, the expandable graphite is sprinkled onto the binder. The binder is preferably the same as outlined above. In the same way, metallic powder may be integrated into fibrous material or a combination of the expandable graphite and metallic powder may be integrated into fibrous material to achieve EMI shielding properties and fire retardant properties at the same time.

The heating structure 5 includes electrically conductive wires 12, and the cooling structure 6 includes hollow tubes 13. The heating structure 5 and the cooling structure 6 can be seen best in Fig. 2. Here, the heating structure 5 and the cooling structure 6 are integrated into one layer and are stitched to fibrous material 14, which can be the same as the fibrous material 7 of the fiber-reinforced plastic 2 or can be another fibrous material. The heating structure 5 and the cooling structure 6 meander through the layer so that the temperature throughout the TMS 1 can be homogenized.

More preferably, the heating structure 5 and the cooling structure 6 are stitched to the fiber material 7 of the fiber-reinforced plastic 2. However, when the heating structure 5 and the cooling structure 6 are stitched to the another fiber material 14, said fibrous material is selected from glass fibers, carbon fibers, polyamide fibers, modacrylic fibers, olefin fibers, polyester fibers, rayon fibers, and mixtures thereof, and preferably the another fiber material 14 is in form of a woven fabric, a non-woven fabric, a non-crimp fabric or a fleece and is optionally impregnated with a resin selected from polyester resins, epoxy resins, phenolic resins, silicone resins, polyamide resins and mixture and copolymers thereof.

The electrically conductive wires 12 of the heating structure 5 are preferably formed from copper, aluminium, iron, nickel, mixtures and alloys therefrom and have an inner diameter ranging from 0.1 to 2.0 mm.

The hollow tubes 13 of the cooling structure 6 are formed from silicon or a plastic material and the hollow tubes 13 have an inner diameter ranging from 0.1 to 2.0 mm.

The TMS 1 of the embodiment of Fig. 1 has a compact and light-weight structure and can be produced easily in a one-step molding process due to the integration or formation of the fire retardant 4 and the EMI material 3 into fibers, which can be easily integrally formed with a fiber-reinforced structure. Thus, the TMI has high functionality of excellent electromagnetic shielding properties, high flame retardancy, improved mechanical stability, and high ability for adjusting the temperature, while being producible in a facilitated process.

### Bezugszeichenliste

- 1: thermal management system
- 2: fiber-reinforced plastic
- 3: EMI material
- 4: fire retardant
- 5: heating structure
- 6: cooling structure
- 7: fibrous material of the fiber-reinforced plastic
- 8: resin
- 9: second layer
- 10: fiber material of the second layer
- 11: binder of the second layer
- 12: electrically conductive wire
- 13: hollow tube
- 14: another fiber material

- t: thickness of the second layer

## Claims

1. A thermal management composite sheet (1) comprising, integrated into a fiber-reinforced plastic (2):
• an electromagnetic interference shielding material (3),
• a fire retardant (4), and
• a heating structure (5) and/or a cooling structure (6),
wherein the heating structure (5) includes electrically conductive wires (12),
wherein the cooling structure (6) includes hollow tubes (13), and
wherein the heating structure (5) and/or the cooling structure (6) is stitched to a fiber material (7, 14).

2. The thermal management composite sheet (1) according to claim 1, wherein the electromagnetic interference shielding material (3) forms a first layer, the fire retardant (4) forms a second layer (9) and the heating structure (5) and/or the cooling structure (6) form at least a third layer, wherein the first, second (9) and third layer(s) are integrated into the fiber-reinforced plastic (2) or
wherein the electromagnetic interference shielding material (3) and the fire retardant (4) form a fourth layer and the heating structure (5) and/or the cooling structure (6) form at least a third layer, wherein the fourth layer and the third layer(s) are integrated into the fiber-reinforced plastic (2) or
wherein the electromagnetic interference shielding material (3), the fire retardant (4) and the heating structure (5) and/or the cooling structure (6) form a fifth layer, wherein the fifth layer is integrated into the fiber-reinforced plastic (2).

3. The thermal management composite sheet (1) according to claim 1 or 2, wherein the fiber material (7) includes at least one of the following fibers: glass fibers, carbon fibers and recycled carbon fibers and/or wherein the plastic material (8) of the fiber-reinforced plastic (2) is at least one selected from the group consisting of: polyester resins, epoxy resins, phenolic resins, silicone resins, polyamide resins and mixture and copolymers thereof.

4. The thermal management composite sheet (1) according to any one of the preceding claims, wherein the electromagnetic interference shielding material (3) includes metal coated fibers, wherein the fibers are particularly selected from carbon fibers, glass fibers, polyester fibers, nylon fibers, aramid fibers, modacrylic fibers, olefin fibers, acrylic fibers, rayon fibers, polyamide fibers, and mixtures thereof, and/or wherein the metal of the metal coated fibers is selected from copper, aluminium, silver, cobalt, nickel, mixtures and alloys therefrom, wherein particularly, the fibers of the electromagnetic interference shielding material (3) form a woven fabric, a non-woven fabric, a non-crimp fabric or a fleece.

5. The thermal management composite sheet (1) according to any one of the preceding claims, wherein the fire retardant (4) includes expandable graphite, wherein particularly, the fire retardant (4) is provided in form of a second layer (9), the second layer (9) including a fiber material (10) selected from the group consisting of: carbon fibers, glass fibers, polyester fibers, aramid fibers, metal-coated carbon fibers, polyphenylenesulphide fibers, polyyetherimide fibers, polyether ether ketone fibers, polyimide fibers and mixtures thereof, and the second layer (9) further including a binder (11) selected from polyvinyl alcohol, polyester resins, styrene acrylic acid resins, polyimide resins, epoxy resins, polyurethane resins and mixtures thereof.

6. The thermal management composite sheet (1) according to any one of claims 2 to 5, wherein the thickness (t) of the second layer (9) ranges from 30 µm to 6 mm, and/or wherein the areal weight of the second layer (9) ranges from 2 to 200 g/m³, and/or wherein a fiber length of the fiber material (10) ranges from 3 to 25 mm.

7. The thermal management composite sheet (1) according to any one of the preceding claims, wherein the electrically conductive wires (12) of the heating structure (5) are formed from copper, aluminium, iron, nickel, mixtures and alloys therefrom, and/or
wherein the electrically conductive wires (12) have an inner diameter ranging from 0.1 to 2.0 mm and/or
wherein the hollow tubes (13) of the cooling structure (6) are formed from silicon or a plastic material and/or wherein the hollow tubes (13) have an inner diameter ranging from 0.1 to 2.0 mm.

8. The thermal management composite sheet (1) according to any one of the preceding claims, wherein the heating structure (5) and the cooling structure (6) are stitched to the fiber material (7) of the fiber-reinforced plastic (2) or wherein the heating structure (5) and the cooling structure (6) are stitched to another fiber material (14), selected from glass fibers, carbon fibers, polyamide fibers, modacrylic fibers, olefin fibers, polyester fibers, rayon fibers, and mixtures thereof, wherein the another fiber material (14) is in form of a woven fabric, a non-woven fabric, a non-crimp fabric or a fleece and is optionally impregnated with a resin selected from polyester resins, epoxy resins, phenolic resins, silicone resins, polyamide resins and mixture and copolymers thereof and/or wherein the heating structure (5) and the cooling structure (6) have a meandering structure.

9. Method for producing a thermal management composite sheet (1) according to claim 1, the method comprising:
• placing a thermal management device and a fiber-based reinforcing material in a mold,
• closing the mold,
• applying pressure and optionally heat, and
• introducing a resin (8) into the mold, said resin infiltrating the fiber-based reinforcing material, and
• when the resin (8) is a thermosetting resin, curing the resin (8) or when the resin (8) is a thermoplastic resin, removing the thermal management composite sheet (1) from the mold and cooling the same, wherein
the thermal management device comprises an electromagnetic interference shielding material (3), a fire retardant (4), and a heating structure (5) and/or a cooling structure (6), wherein the heating structure (5) includes electrically conductive wires (12), wherein the cooling structure (6) includes hollow tubes (13), and wherein the heating structure (5) and/or the cooling structure (6) is stitched to a fiber material (7) of the fiber-based reinforcing material.

10. The method of claim 9, wherein the electromagnetic interference shielding material (3) is in form of a first layer, the fire retardant (4) is in form of a second layer (9) and the heating structure (5) and/or the cooling structure (6) is in form of at least a third layer or
wherein the electromagnetic interference shielding material (3) and the fire retardant (4) are in form of a fourth layer and the heating structure (5) and/or the cooling structure (6) is in form of at least a third layer, or
wherein the electromagnetic interference shielding material (3), the fire retardant (4) and the heating structure (5) and/or the cooling structure (6) are in form of a fifth layer.

11. The method of claim 10, wherein the first to fifth layer include a fiber material and a resin.

12. The method of claim 10 or 11, wherein the fourth layer is formed by the following steps:
• providing the electromagnetic interference shielding material (3), wherein the electromagnetic interference shielding material (3) includes metal coated fibers, wherein the fibers are particularly selected from glass fibers, polyamide fibers, modacrylic fibers, olefin fibers, polyester fibers, rayon fibers and mixtures thereof, and/or wherein the metal of the metal coated fibers is selected from copper, aluminium, silver, cobalt, nickel, mixtures and alloys therefrom, wherein the fibers of the electromagnetic interference shielding material form a woven fabric, a non-woven fabric, a non-crimp fabric or a fleece,
• applying binder on the electromagnetic interference shielding material, and
• applying the flame retardant (4) on the fibers with binders of the electromagnetic interference shielding material (3).

13. A car, a battery case, a computer case or a sensor case comprising the thermal management composite sheet (1) according to any of claims 1 to 8.

14. The car of claim 13, wherein the thermal management composite sheet (1) is connected to an air conditioning of the car.

15. The car of claim 14, wherein a coolant supplied to the cooling structure of the thermal management composite sheet (1) is a chemically stabilized CO₂ based air coolant.

## Patentansprüche

1. Wärmemanagement-Verbundplatte (1), umfassend, integriert in einen faserverstärkten Kunststoff (2):
• ein Abschirmmaterial (3) gegen elektromagnetische Interferenz,
• ein Flammschutzmittel (4), und
• eine Heizstruktur (5) und/oder eine Kühlstruktur (6),
wobei die Heizstruktur (5) elektrisch leitende Drähte (12) umfasst, wobei die Kühlstruktur (6) Hohlrohre (13) umfasst, und
wobei die Heizstruktur (5) und/oder die Kühlstruktur (6) mit einem Fasermaterial (7, 14) vernäht ist.

2. Wärmemanagement-Verbundplatte (1) nach Anspruch 1, wobei das Abschirmmaterial (3) gegen elektromagnetische Interferenz eine erste Schicht bildet, das Flammschutzmittel (4) eine zweite Schicht (9) bildet und die Heizstruktur (5) und/oder die Kühlstruktur (6) mindestens eine dritte Schicht bilden, wobei die erste, zweite (9) und dritte Schicht(en) in den faserverstärkten Kunststoff (2) integriert sind oder
wobei das Abschirmmaterial (3) gegen elektromagnetische Interferenz und das Flammschutzmittel (4) eine vierte Schicht bilden und die Heizstruktur (5) und/oder die Kühlstruktur (6) mindestens eine dritte Schicht bilden, wobei die vierte Schicht und die dritte Schicht(en) in den faserverstärkten Kunststoff (2) integriert sind oder
wobei das Abschirmmaterial (3) gegen elektromagnetische Interferenz, das Flammschutzmittel (4) und die Heizstruktur (5) und/oder die Kühlstruktur (6) eine fünfte Schicht bilden, wobei die fünfte Schicht in den faserverstärkten Kunststoff (2) integriert ist.

3. Wärmemanagement-Verbundplatte (1) nach Anspruch 1 oder 2, wobei das Fasermaterial (7) mindestens eine der folgenden Fasern umfasst: Glasfasern, Kohlenstofffasern und recycelte Kohlenstofffasern und/oder wobei das Kunststoffmaterial (8) des faserverstärkten Kunststoffs (2) mindestens eines ist, ausgewählt aus der Gruppe bestehend aus: Polyesterharzen, Epoxidharzen, Phenolharzen, Silikonharzen, Polyamidharzen und Mischungen und Copolymeren davon.

4. Wärmemanagement-Verbundplatte (1) nach einem der vorhergehenden Ansprüche, wobei das Abschirmmaterial (3) gegen elektromagnetische Interferenz metallbeschichtete Fasern umfasst, wobei die Fasern insbesondere ausgewählt sind aus Kohlenstofffasern, Glasfasern, Polyesterfasern, Nylonfasern, Aramidfasern, Modacrylfasern, Olefinfasern, Acrylfasern, Rayonfasern, Polyamidfasern und Mischungen davon und/oder wobei das Metall der metallbeschichteten Fasern ausgewählt ist aus Kupfer, Aluminium, Silber, Kobalt, Nickel, Mischungen und Legierungen davon, wobei insbesondere die Fasern des Abschirmmaterials (3) gegen elektromagnetische Interferenz einen gewebten Stoff, einen nicht gewebten Stoff, einen nicht gekräuselten Stoff oder ein Vlies bilden.

5. Wärmemanagement-Verbundplatte (1) nach einem der vorhergehenden Ansprüche, wobei das Flammschutzmittel (4) expandierbares Graphit umfasst, wobei insbesondere das Flammschutzmittel (4) in Form einer zweiten Schicht (9) bereitgestellt ist, wobei die zweite Schicht (9) ein Fasermaterial (10) umfasst, ausgewählt aus der Gruppe bestehend aus: Kohlenstofffasern, Glasfasern, Polyesterfasern, Aramidfasern, metallbeschichteten Kohlenstofffasern, Polyphenylensulfidfasern, Polyetherimidfasern, Polyetheretherketonfasern, Polyimidfasern und Mischungen davon, und die zweite Schicht (9) ferner ein Bindemittel (11) umfasst, ausgewählt aus Polyvinylalkohol, Polyesterharzen, Styrolacrylsäureharzen, Polyimidharzen, Epoxidharzen, Polyurethanharzen und Mischungen davon.

6. Wärmemanagement-Verbundplatte (1) nach einem der Ansprüche 2 bis 5, wobei die Dicke (t) der zweiten Schicht (9) im Bereich von 30 µm bis 6 mm liegt und/oder wobei das Flächengewicht der zweiten Schicht (9) im Bereich von 2 bis 200 g/m³ liegt und/oder wobei eine Faserlänge des Fasermaterials (10) im Bereich von 3 bis 25 mm liegt.

7. Wärmemanagement-Verbundplatte (1) nach einem der vorhergehenden Ansprüche, wobei die elektrisch leitenden Drähte (12) der Heizstruktur (5) aus Kupfer, Aluminium, Eisen, Nickel, Mischungen und Legierungen davon gebildet sind und/oder
wobei die elektrisch leitenden Drähte (12) einen Innendurchmesser im Bereich von 0,1 bis 2,0 mm aufweisen und/oder
wobei die Hohlrohre (13) der Kühlstruktur (6) aus Silizium oder einem Kunststoffmaterial gebildet sind und/oder wobei die Hohlrohre (13) einen Innendurchmesser im Bereich von 0,1 bis 2,0 mm aufweisen.

8. Wärmemanagement-Verbundplatte (1) nach einem der vorhergehenden Ansprüche, wobei die Heizstruktur (5) und die Kühlstruktur (6) mit dem Fasermaterial (7) des faserverstärkten Kunststoffs (2) vernäht sind oder wobei die Heizstruktur (5) und die Kühlstruktur (6) mit einem anderen Fasermaterial (14) vernäht sind, ausgewählt aus Glasfasern, Kohlenstofffasern, Polyamidfasern, Modacrylfasern, Olefinfasern, Polyesterfasern, Rayonfasern und Mischungen davon, wobei das andere Fasermaterial (14) in Form eines gewebten Stoffs, eines nicht gewebten Stoffs, eines nicht gekräuselten Stoffs oder eines Vlieses vorliegt und optional mit einem Harz imprägniert ist, ausgewählt aus Polyesterharzen, Epoxidharzen, Phenolharzen, Silikonharzen, Polyamidharzen und Mischungen und Copolymeren davon und/oder wobei die Heizstruktur (5) und die Kühlstruktur (6) eine mäanderförmige Struktur aufweisen.

9. Verfahren zum Herstellen einer Wärmemanagement-Verbundplatte (1) nach Anspruch 1, wobei das Verfahren Folgendes umfasst:
• Platzieren einer Wärmemanagementvorrichtung und eines faserbasierten Verstärkungsmaterials in einer Form,
• Schließen der Form,
• Anwenden von Druck und optional Wärme, und
• Einführen eines Harzes (8) in die Form, wobei das Harz das faserbasierte Verstärkungsmaterial infiltriert, und
• wenn das Harz (8) ein wärmehärtendes Harz ist, Aushärten des Harzes (8) oder wenn das Harz (8) ein thermoplastisches Harz ist, Entfernen der Wärmemanagement-Verbundplatte (1) aus der Form und Kühlen derselben, wobei
die Wärmemanagementvorrichtung ein Abschirmmaterial (3) gegen elektromagnetische Interferenz, ein Feuerschutzmittel (4) und eine Heizstruktur (5) und/oder eine Kühlstruktur (6) umfasst, wobei die Heizstruktur (5) elektrisch leitende Drähte (12) umfasst, wobei die Kühlstruktur (6) Hohlrohre (13) umfasst, und wobei die Heizstruktur (5) und/oder die Kühlstruktur (6) mit einem Fasermaterial (7) des faserbasierten Verstärkungsmaterials vernäht ist.

10. Verfahren nach Anspruch 9, wobei das Abschirmmaterial (3) gegen elektromagnetische Interferenz in Form einer ersten Schicht vorliegt, das Flammschutzmittel (4) in Form einer zweiten Schicht (9) vorliegt und die Heizstruktur (5) und/oder die Kühlstruktur (6) in Form mindestens einer dritten Schicht vorliegt oder
wobei das Abschirmmaterial (3) gegen elektromagnetische Interferenz und das Flammschutzmittel (4) in Form einer vierten Schicht vorliegen und die Heizstruktur (5) und/oder die Kühlstruktur (6) in Form mindestens einer dritten Schicht vorliegt oder
wobei das Abschirmmaterial (3) gegen elektromagnetische Interferenz, das Flammschutzmittel (4) und die Heizstruktur (5) und/oder die Kühlstruktur (6) in Form einer fünften Schicht vorliegen.

11. Verfahren nach Anspruch 10, wobei die erste bis fünfte Schicht ein Fasermaterial und ein Harz umfassen.

12. Verfahren nach Anspruch 10 oder 11, wobei die vierte Schicht durch die folgenden Schritte gebildet wird:
• Bereitstellen des Abschirmmaterials (3) gegen elektromagnetische Interferenz, wobei das Abschirmmaterial (3) gegen elektromagnetische Interferenz metallbeschichtete Fasern umfasst, wobei die Fasern insbesondere ausgewählt sind aus Glasfasern, Polyamidfasern, Modacrylfasern, Olefinfasern, Polyesterfasern, Rayonfasern und Mischungen davon und/oder wobei das Metall der metallbeschichteten Fasern ausgewählt ist aus Kupfer, Aluminium, Silber, Kobalt, Nickel, Mischungen und Legierungen davon, wobei die Fasern des Abschirmmaterials gegen elektromagnetische Interferenz einen gewebten Stoff, einen nicht gewebten Stoff, einen nicht gekräuselten Stoff oder ein Vlies bilden,
• Aufbringen eines Bindemittels auf das Abschirmmaterial gegen elektromagnetische Interferenz und
• Aufbringen des Flammschutzmittels (4) auf die Fasern mit Bindemitteln des Abschirmmaterials (3) gegen elektromagnetische Interferenz.

13. Auto, Batteriegehäuse, Computergehäuse oder Sensorgehäuse, umfassend die Wärmemanagement-Verbundplatte (1) nach einem der Ansprüche 1 bis 8.

14. Auto nach Anspruch 13, wobei die Wärmemanagement-Verbundplatte (1) mit einer Klimaanlage des Autos verbunden ist.

15. Auto nach Anspruch 14, wobei ein Kühlmittel, das der Kühlstruktur der Wärmemanagement-Verbundplatte (1) zugeführt wird, ein chemisch stabilisiertes CO₂ - basiertes Luftkühlmittel ist.

## Revendications

1. Feuille composite de gestion thermique (1) comprenant, intégré dans un plastique renforcé de fibres (2) :
• un matériau de blindage contre les interférences électromagnétiques (3),
• un ignifuge (4), et
• une structure chauffante (5) et/ou une structure de refroidissement (6),
dans laquelle la structure chauffante (5) comprend des fils électriquement conducteurs (12), dans laquelle la structure de refroidissement (6) comprend des tubes creux (13), et
dans laquelle la structure chauffante (5) et/ou la structure de refroidissement (6) est cousue à un matériau fibreux (7, 14).

2. Feuille composite de gestion thermique (1) selon la revendication 1, dans laquelle le matériau de blindage contre les interférences électromagnétiques (3) forme une première couche, l'ignifuge (4) forme une deuxième couche (9) et la structure chauffante (5) et/ou la structure de refroidissement (6) forment au moins une troisième couche, dans laquelle les première, deuxième (9) et troisième (s) couches sont intégrées dans le plastique renforcé de fibres (2) ou
dans laquelle le matériau de blindage contre les interférences électromagnétiques (3) et l'ignifuge (4) forment une quatrième couche et la structure chauffante (5) et/ou la structure de refroidissement (6) forment au moins une troisième couche, dans laquelle la quatrième couche et la (les) troisième(s) couche(s) sont intégrées dans le plastique renforcé de fibres (2) ou
dans laquelle le matériau de blindage contre les interférences électromagnétiques (3), l'ignifuge (4) et la structure chauffante (5) et/ou la structure de refroidissement (6) forment une cinquième couche, dans laquelle la cinquième couche est intégrée dans le plastique renforcé de fibres (2).

3. Feuille composite de gestion thermique (1) selon la revendication 1 ou 2, dans laquelle le matériau de fibres (7) comprend au moins l'une des fibres suivantes : des fibres de verre, des fibres de carbone et des fibres de carbone recyclées et/ou dans laquelle le matériau plastique (8) du plastique renforcé de fibres (2) est au moins l'un choisi dans le groupe constitué par : des résines de polyester, des résines époxy, des résines phénoliques, des résines de silicone, des résines de polyamide et leurs mélanges et copolymères.

4. Feuille composite de gestion thermique (1) selon l'une quelconque des revendications précédentes, dans laquelle le matériau de blindage contre les interférences électromagnétiques (3) comprend des fibres revêtues de métal, dans laquelle les fibres sont en particulier choisies parmi des fibres de carbone, des fibres de verre, des fibres de polyester, des fibres de nylon, des fibres d'aramide, des fibres modacryliques, des fibres d'oléfine, des fibres acryliques, des fibres de rayonne, des fibres de polyamide, et leurs mélanges, et/ou dans laquelle le métal des fibres revêtues de métal est choisi parmi le cuivre, l'aluminium, l'argent, le cobalt, le nickel, leurs mélanges et alliages, dans laquelle en particulier, les fibres du matériau de blindage contre les interférences électromagnétiques (3) forment un tissu tissé, un tissu non tissé, un tissu non frisé ou un non-tissé.

5. Feuille composite de gestion thermique (1) selon l'une quelconque des revendications précédentes, dans laquelle l'ignifuge (4) comprend du graphite expansible, dans laquelle en particulier, l'ignifuge (4) est fourni sous la forme d'une deuxième couche (9), la deuxième couche (9) comprenant un matériau de fibres (10) choisi dans le groupe constitué par : des fibres de carbone, des fibres de verre, des fibres de polyester, des fibres d'aramide, des fibres de carbone revêtues de métal, des fibres de sulfure de polyphénylène, des fibres de polyétherimide, des fibres de polyétheréthercétone, des fibres de polyimide et leurs mélanges, et la deuxième couche (9) comprenant en outre un liant (11) choisi parmi l'alcool polyvinylique, des résines de polyester, des résines de styrène-acide acrylique, des résines de polyimide, des résines époxy, des résines de polyuréthane et leurs mélanges.

6. Feuille composite de gestion thermique (1) selon l'une quelconque des revendications 2 à 5, dans laquelle l'épaisseur (t) de la deuxième couche (9) va de 30 µm à 6 mm, et/ou dans laquelle le poids surfacique de la deuxième couche (9) va de 2 à 200 g/m³ , et/ou dans laquelle une longueur de fibre du matériau de fibres (10) va de 3 à 25 mm.

7. Feuille composite de gestion thermique (1) selon l'une quelconque des revendications précédentes, dans laquelle les fils électriquement conducteurs (12) de la structure chauffante (5) sont formés à partir de cuivre, d'aluminium, de fer, de nickel, leurs mélanges et alliages, et/ou
dans laquelle les fils électriquement conducteurs (12) ont un diamètre interne allant de 0,1 à 2,0 mm et/ou
dans laquelle les tubes creux (13) de la structure de refroidissement (6) sont formés à partir de silicium ou d'un matériau plastique et/ou dans laquelle les tubes creux (13) ont un diamètre interne allant de 0,1 à 2,0 mm.

8. Feuille composite de gestion thermique (1) selon l'une quelconque des revendications précédentes, dans laquelle la structure chauffante (5) et la structure de refroidissement (6) sont cousues au matériau de fibres (7) du plastique renforcé de fibres (2) ou dans laquelle la structure chauffante (5) et la structure de refroidissement (6) sont cousues à un autre matériau de fibres (14), choisi parmi des fibres de verre, des fibres de carbone, des fibres de polyamide, des fibres modacryliques, des fibres d'oléfine, des fibres de polyester, des fibres de rayonne, et leurs mélanges, dans laquelle l'autre matériau de fibres (14) est sous la forme d'un tissu tissé, d'un tissu non tissé, d'un tissu non frisé ou d'un non-tissé et est facultativement imprégné avec une résine choisie parmi des résines de polyester, des résines époxy, des résines phénoliques, des résines de silicone, des résines de polyamide et leurs mélanges et copolymères et/ou dans laquelle la structure chauffante (5) et la structure de refroidissement (6) ont une structure sinueuse.

9. Procédé de production d'une feuille composite de gestion thermique (1) selon la revendication 1, le procédé comprenant :
• le placement d'un dispositif de gestion thermique et d'un matériau de renforcement à base de fibres dans un moule,
• la fermeture du moule,
• l'application d'une pression et facultativement de chaleur, et
• l'introduction d'une résine (8) dans le moule, ladite résine infiltrant le matériau de renforcement à base de fibres, et
• lorsque la résine (8) est une résine thermodurcissable, le durcissement de la résine (8) ou lorsque la résine (8) est une résine thermoplastique, le retrait de la feuille composite de gestion thermique (1) du moule et le refroidissement de celle-ci, dans lequel
le dispositif de gestion thermique comprend un matériau de blindage contre les interférences électromagnétiques (3), un ignifuge (4), et une structure chauffante (5) et/ou une structure de refroidissement (6), dans lequel la structure chauffante (5) comprend des fils électriquement conducteurs (12), dans lequel la structure de refroidissement (6) comprend des tubes creux (13), et dans lequel la structure chauffante (5) et/ou la structure de refroidissement (6) est cousue à un matériau fibreux (7) du matériau de renforcement à base de fibres.

10. Procédé selon la revendication 9, dans lequel le matériau de blindage contre les interférences électromagnétiques (3) est sous la forme d'une première couche, l'ignifuge (4) est sous la forme d'une deuxième couche (9) et la structure chauffante (5) et/ou la structure de refroidissement (6) est sous la forme d'au moins une troisième couche ou
dans lequel le matériau de blindage contre les interférences électromagnétiques (3) et l'ignifuge (4) sont sous la forme d'une quatrième couche et la structure chauffante (5) et/ou la structure de refroidissement (6) est sous la forme d'au moins une troisième couche, ou
dans lequel le matériau de blindage contre les interférences électromagnétiques (3), l'ignifuge (4) et la structure chauffante (5) et/ou la structure de refroidissement (6) sont sous la forme d'une cinquième couche.

11. Procédé selon la revendication 10, dans lequel les première à cinquième couches comprennent un matériau fibreux et une résine.

12. Procédé selon la revendication 10 ou 11, dans lequel la quatrième couche est formée par les étapes suivantes :
• la fourniture du matériau de blindage contre les interférences électromagnétiques (3), dans lequel le matériau de blindage contre les interférences électromagnétiques (3) comprend des fibres revêtues de métal, dans lequel les fibres sont en particulier choisies parmi des fibres de verre, des fibres de polyamide, des fibres modacryliques, des fibres d'oléfine, des fibres de polyester, des fibres de rayonne et leurs mélanges, et/ou dans lequel le métal des fibres revêtues de métal est choisi parmi le cuivre, l'aluminium, l'argent, le cobalt, le nickel, leurs mélanges et alliages, dans lequel les fibres du matériau de blindage contre les interférences électromagnétiques forment un tissu tissé, un tissu non tissé, un tissu non frisé ou un non-tissé,
• l'application d'un liant sur le matériau de blindage contre les interférences électromagnétiques, et
• l'application du retardateur de flamme (4) sur les fibres avec des liants du matériau de blindage contre les interférences électromagnétiques (3).

13. Voiture, boîtier de batterie, boîtier d'ordinateur ou boîtier de capteur comprenant la feuille composite de gestion thermique (1) selon l'une quelconque des revendications 1 à 8.

14. Voiture selon la revendication 13, dans laquelle la feuille composite de gestion thermique (1) est reliée à un climatiseur de la voiture.

15. Voiture selon la revendication 14, dans laquelle un réfrigérant fourni à la structure de refroidissement de la feuille composite de gestion thermique (1) est un réfrigérant à air à base de CO₂ stabilisé chimiquement.
